Europäisches Patentamt

European Patent Office

Office européen des brevets

(11) Publication number: **0 007 183**
**B1**

## EUROPEAN PATENT SPECIFICATION

(45) Date of publication of patent specification:
**29.04.81**

(21) Application number: **79301162.8**

(22) Date of filing: **18.06.79**

(51) Int. Cl.³: **H 01 R  43/00, H 01 R  23/68**

(54) An electrical connector assembly and apparatus for, and a method of, manufacturing the assembly.

(30)  Priority: **17.07.78  US 925489**

(43)  Date of publication of application:
**23.01.80 Bulletin 80/2**

(45)  Publication of the grant of the patent:
**29.04.81 Bulletin 81/17**

(84)  Designated Contracting States:
**BE DE FR GB IT NL SE**

(56)  References cited:
**US-A-3 793 720**
**US-A-3 801 953**
**US-A-4 077 694**
**US-A-4 089 104**

(73)  Proprietor: **AMP INCORPORATED, Eisenhower
Boulevard, Harrisburg, Pennsylvania (US)**

(72)  Inventor: **Cobaugh, Robert Franklin, Box 144A R.D. No.2,
Elizabethtown Pennsylvania (US)**
Inventor: **Katzaman, Ronald Eugene, 8013 Evelyn Street
R.D. No.3, Hummelstown Pennsylvania (US)**
Inventor: **Taylor, Attalee Snarr, 430E, R.D. No.1, Palmyra
Pennsylvania (US)**

(74)  Representative: **Terrell, Thomas Gwyn et al,
20 Queensmere, Slough, Berkshire SL1 1YZ (GB)**

## An electrical connector assembly and apparatus for, and a method of, manufacturing the assembly

This invention relates to an electrical connector assembly and apparatus for, and a method of, manufacturing the assembly.

There is disclosed in US-A-3 609 633, an electrical connector assembly comprising a plurality of electrical terminals each having an electrical contact portion and an electrical connecting post having a free end, an insulating housing enclosing the contact portions of the terminals and from which housing the connecting posts of the terminals project, the posts extending through holes in an insulating strip which serves to retain the posts in parallel relationship with one another, the terminals having enlarged portions intermediate their ends and the strip being positioned between the free ends of the posts and the enlarged portions.

In this known assembly, the enlarged portions of the terminals serve as stops which limit the insertion of the posts of the terminals through the holes in the insulating strip which is in the form of an elastomeric block of considerable thickness.

The present invention concerns the problem of aligning the connecting posts of a free standing electrical connector, according for example, to US-A-4 077 694 in which the posts are somewhat loosely confined by the housing, the base of which is constituted by a printed circuit board into holes in which the posts are inserted by the end user of the connector, the enlarged portions of the terminals being formed on the posts and being adapted to be force fitted into the holes in the printed circuit board to stabilize the terminals with respect thereto. Since, as mentioned above, the terminals are somewhat loosely confined by the housing, the terminals tend, prior to the assembly of the connector to the printed circuit board, to shift relative to one another so that the posts do not extend from the housing in exactly parallel relationship with respect to one another, so that difficulty is experienced in inserting the posts into the holes in the printed circuit board.

According to one aspect of the present invention, therefore, an electrical connector assembly as defined in the second paragraph of this specification is characterised in that the malleability of the material of the strip and the thickness thereof are so chosen, and the enlarged portions, which portions are on the posts, are so shaped, that the enlarged portions can be forced through the holes in the strip.

The insulating strip therefore serves to keep the posts in precise alignment so that the posts can be inserted into holes into a printed circuit board without first mutually aligning the posts.

Although there is disclosed in US-A-3 793 720 an assembly of electrical circuit components e. g. resistors and capacitors, in which the leads of these components extend through an insulating support strip and are, in use of the assembly, inserted further through the insulating strip into holes in a mounting board, the leads do not have enlarged portions to be forced into the holes in the mounting board, and there is nothing in the specification to suggest that such enlarged portions could be forced through the insulating strip.

According to another aspect of the invention, apparatus for manufacturing an assembly according to the invention is characterised by a jig having a strip receiving face on which the insulating strip is positioned, bores in the jig communicating with the strip receiving face of the jig, each bore being in alignment with one of the holes in the strip; means securing the strip releasably on the strip receiving face; means for moving the jig along a strip conveying path; terminal insertion tooling mounted beside the path at a terminal insertion station of the jig and comprising a vice for gripping a plurality of the terminals, the vice being movable towards the conveying path to insert the posts of the terminals through the holes in the strip and into the bores of the jig; a housing applicator mounted beside the conveying path at a housing application station downstream of the terminal application station and being adapted to position the housing over the contact portions of the terminals; and connector assembly stripping tooling mounted at a connector assembly stripping station of the jig downstream of the housing application station and being adapted to release the strip from the strip securing means and to withdraw from the jig the housing with the terminals therein and the posts of the terminals extending through the holes in the strip, the stripping tooling comprising means for positoning the insulating strip in the vicinity of the free ends of the posts.

According to a further aspect of the invention, a method of manufacturing an assembly according to the invention is characterised by the steps of; securing the insulating strip in a jig, the holes in the strip being arranged in first and second parallel rows, and each such hole being axially aligned with one of a plurality of bores in the jig; employing first insertion tooling to insert the free end of the post of each terminal of a first row of terminals through one of the holes of the first row and into the bore aligned therewith, employing second insertion tooling to insert the free end of the post of each terminal cf a second row of terminals through one of the holes of the second row and into the bore aligned therewith; employing a housing applicator to secure the housing about the contact portions of the two rows of terminals held by the jig; and employing locating and stripping tooling to position the insulating strip in the vicinity of the ends of the posts of the terminals of the two rows and to remove the finished assembly from the jig.

The state of the art is further exemplified by US-A-3 807 045, US-A-3 801 953, US-A-3 800 416, US-A-3 875 636 and US-A-3 545 606.

For a better understanding of the present invention reference will now be made by way of example to the accompanying drawings, in which:

Fig. 1 is a perspective view of a freestanding electrical connector assembly positioned for mounting on a printed circuit board, the assembly comprising an electrical connector and an insulating strip aligning terminal posts of the connector;

Fig. 1A is a cross-sectional view showing the connector assembly after it has been mounted on the printed circuit board;

Fig. 2 is a perspective view of a modified form of the insulating strip;

Fig. 3 is a diagrammatic plan view of apparatus for manufacturing the connector assembly;

Fig. 4 is a perspective view of a part of a jig of the apparatus;

Fig. 4A is a sectional view taken on the lines IVA-IVA of Fig. 4;

Figs. 5A, 5B and 5C are fragmentary views shown partly in section, illustrating respective successive stages in the operation of terminal insertion tooling of the apparatus, co-operating with the jig;

Fig. 6 is a perspective view of part of a strip of electrical terminals for use with the apparatus;

Figs. 7A, 7B and 7C are elevational views, shown partly in section, illustrating respective successive stages in the operation of connector housing application tooling of the apparatus, co-operating with the jig;

Fig. 8 is a fragmentary longitudinal sectional view of Fig. 7C but in which the jig is not shown; and

Figs. 9 to 13 are fragmentary views shown partly in section illustrating respective successive stages in the operation of a connector assembly stripping tooling of the apparatus, co-operating with the jig.

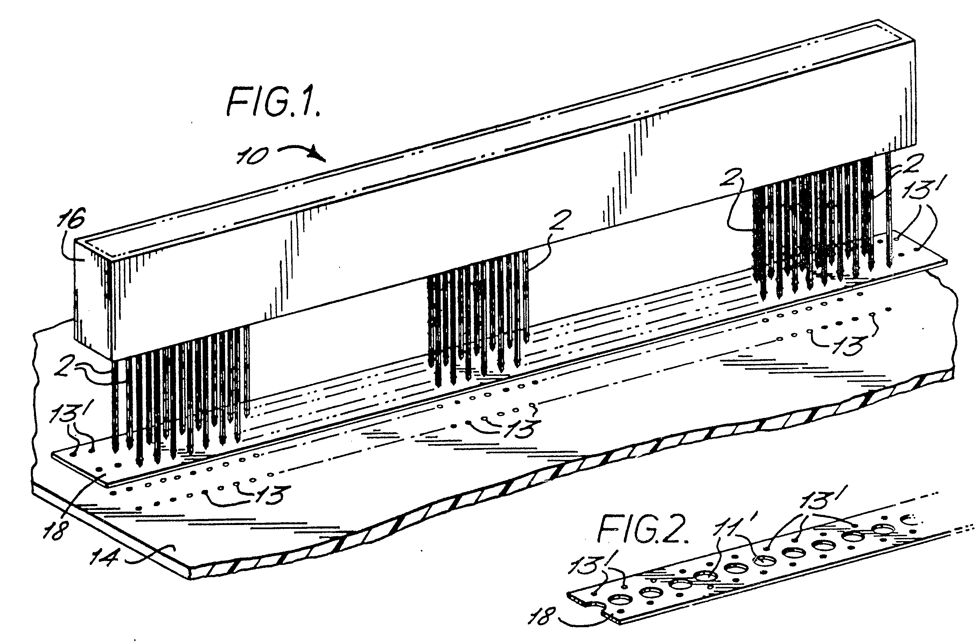

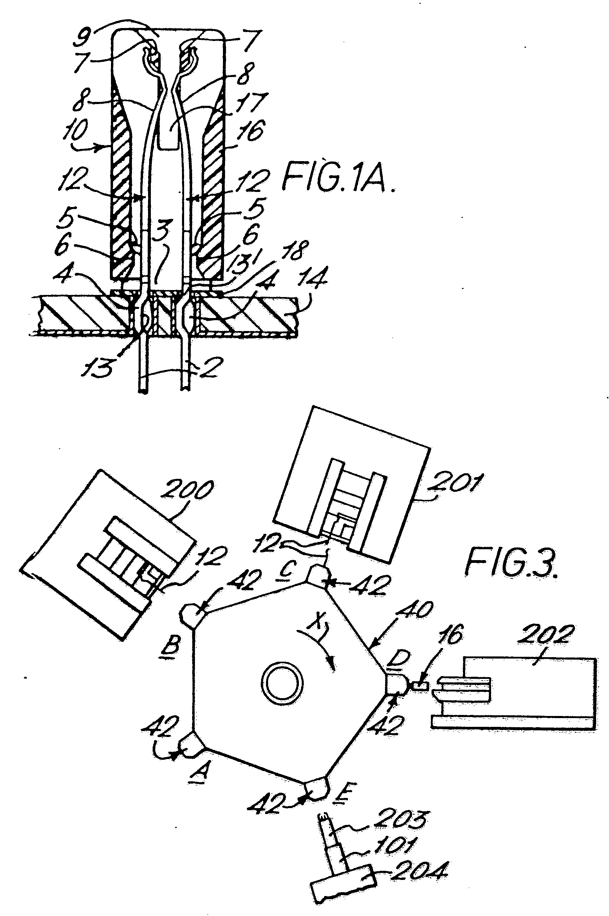

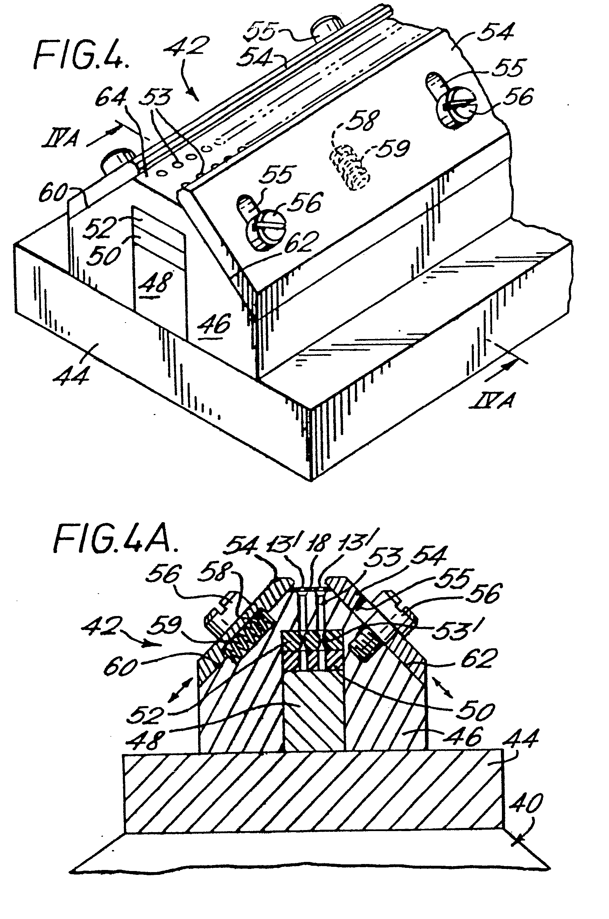

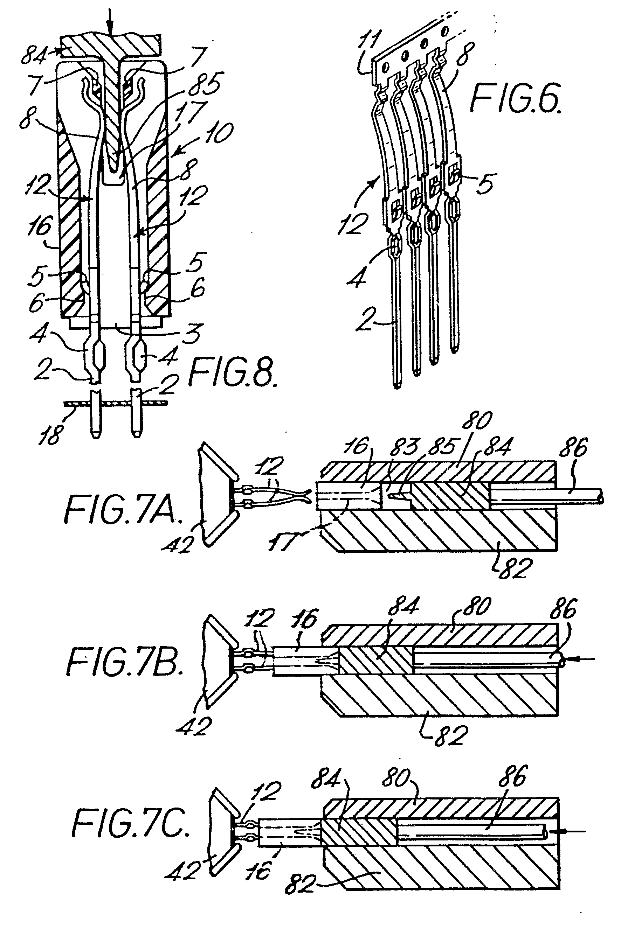

As best seen in Figs. 1, 1A and 8, a freestanding electrical connector 10, which is described in detail in US-A-4 077 694, comprises an insulating housing 16 in which are removably mounted two parallel rows of electrical terminals 12 having square cross-section terminal posts 2 which project through an open bottom end 3 of the housing 16 and which are provided with enlarged, resilient portions 4 (not shown in Fig. 1) which are adapted to be force fitted as shown in Fig. 1A, into holes 13, also arrangend in two parallel rows, of a printed circuit board 14 to secure the terminals 12 firmly to the board 14. As best seen in Fig. 8, the terminals 12 are restrained from withdrawal from the housing 16 through its open end 3, by means of retaining tongues 5 on the terminals 12, which tongues engage against internal projections 6 in the housing 16.

At the opposite end 9 of the housing are ribs 7 which are normally engaged by contact springs 8 of the terminals 12. Since the terminals 12 are thus somewhat loosely retained in the housing 16, they are movable, within limits, with respect to one another, so that in the absence of restraint, the posts 2 would extend in random directions from the housing 16.

The end 9 of the housing is formed with a channel 17 for guiding a printed circuit panel (not shown) between the contact springs 8.

In order to align the terminals 12 so that their posts 2 extend in parallel relationship, whereby the free ends of the posts 2 can be inserted simultaneously into the holes 13 simply by advancing the connector 10 from the positon in which it is shown in Fig. 1, towards the board 14, the posts 2 are initially inserted through two parallel rows of pre-punched holes 13' in an insulating alignment strip 18 which is sufficiently rigid to retain the posts 2 in exactly parallel alignment but which is sufficiently thin and maleable to allow the portions 4 of the posts 2 to be forced through holes 13' of the strip 18, so that the portions 4 seat in the holes 13 of the board 14 as best seen in Fig. 1A. The strip 18, which should not be of a material which will fracture when the posts 14 are forced through the holes 13', may be made of polytetrafluoroethylene and may be of approximately 0.127 mm in thickness, this material being of the required malleability and dimensional stability. Since the strip 18, when made of such material, is transparent, the operator's view of the free ends of the posts 2 and of the holes 13 in the board 14 is unobstructed by the strip 18.

The spacing between the holes 13', corresponds exactly, of course, to that of the holes 13 in the board 14 and each hole 13' is sized to achieve interference between the post 2 extending therethrough, and the strip 18. By way of example, each post 2 may have, as seen in cross-section, sides of 0.635 mm in length and thus a diagonal of 0.8686 mm, each hole 13', assuming it to be circular, having a diameter of 0.762 mm. The interference between the posts 2 and strip 18 must be sufficient to maintain the strip 18 in position longitudinally of the posts 2, without alteration of parallel relationship of the posts 2.

In order to provide for effective alignment of the posts 2, and at the same time to expose sufficient of the free end portions of the posts 2 to permit their ready location in the holes 13 of the board 14, the strip 18 is preferably positioned at less than 8 mm, for example, at about 2.54 mm from the free extremities of the posts 2.

As shown in Fig. 1A, the strip 18 is positioned on the board 14, between the portions 4 of the posts 2 and the housing 16 when the connector 10 has been assembled to the board 14. The strip 18 accordingly provides additional insulation between the terminals 12, the board 14 and the housing 16. When the posts 2 are soldered to printed conductors on the board 14, the strip 18 acts as a barrier to obstruct the flow of molten solcer up the posts 2 during the soldering operation.

The housing 16 can be removed from the terminals 12, leaving them attached to the board 14. In order to provide access to the board 14, the strip 18 may be provided with larger holes 11', as shown in Fig. 2, between the rows of holes 13'.

Apparatus for manufacturing the assembly comprising the terminals 12, the housing 16 and the strip 18, will now be described with reference to Fig. 3 to 13.

As shown in Fig.3, a turret 40 has thereon five constantly peripherally spaced jigs 42, each for holding a strip 18. The turret 40 is rotatable, stepwise and about a vertical central axis, in the direction of the arrow X, by drive means not shown, to position each jig 42 at each of five work stations A to E in turn.

As shown in Figs. 4 and 4A, each jig 42 has a rectangular base 44 secured to the turret 40 (Fig. 4A). On the base 44 is a housing 46 enclosing superposed spacers 48 and 50, surmonunted by a resilient pad 52. The housing 46 has inclined, plane surfaces 60 and 62 converging radially outwardly of the turret 40 and between which is a plane radially outer surface 64 (Fig. 4) dimensioned to support an alignment strip 18. On each surface 60 and 62 is a plate 54 urged towards the surface 64 by means of a spring 58 in a spring chamber 59. The plates 54 are secured to the respective surfaces 60 and 62 by means of screws 56 extending through slots 55 in the plates 54, the springs 58 causing the plates 54 to grip the strip 18 between them.

Two parallel rows of bores 53 each for receiving the free end portion of a post 2 extend through the spacer 48 and the pad 52, in alignment with the holes 13' of the strip 18, as shown in Fig. 4A.

The spacer 48 acts as a bottom stop for the free ends of the posts 2, the height, as seen in Fig. 4A of the spacer 48 being chosen in accordance with the length of the posts 2. The pad 52 may be of synthetic rubber e. g. neoprene, or of any other material which is of sufficient resilience to enable the posts 2 to be secured in the reduced cross-section portions 53' of the bores 53 therein, during the rotation of the turret 40.

In operation of the apparatus, a strip 18 is loaded manually onto the surface 64 of a jig 42 positioned at station A, during a dwell period of the turret 40. At station B the posts 2 of a first row of terminals 12 are inserted into one of the rows of bores 53 of the jig 42, at station C the posts 2 of a second row of therminals 12 are inserted into the other row of bores 53 of the jig 42, at station D a housing 16 is placed over the two rows of terminals 12 projecting from the jig 42 and at station E the finished connector assembly, which includes the strip 18, is stripped from the jig 42. These last four operations are each effected, during a dwell period of the turret 40, by means of tooling described below.

Assoiciated with each of stations B and C is a conventional pneumatic or hydraulic bench press, 200 and 201, respectively, mounted on tracks (not shown) for horizontal movement towards and away from the turret 40. Each press 200 and 201 is fed, in a manner not shown, with a strip of terminals 12 (Fig. 6) connected in juxtaposed relationship by a carrier strip 11.

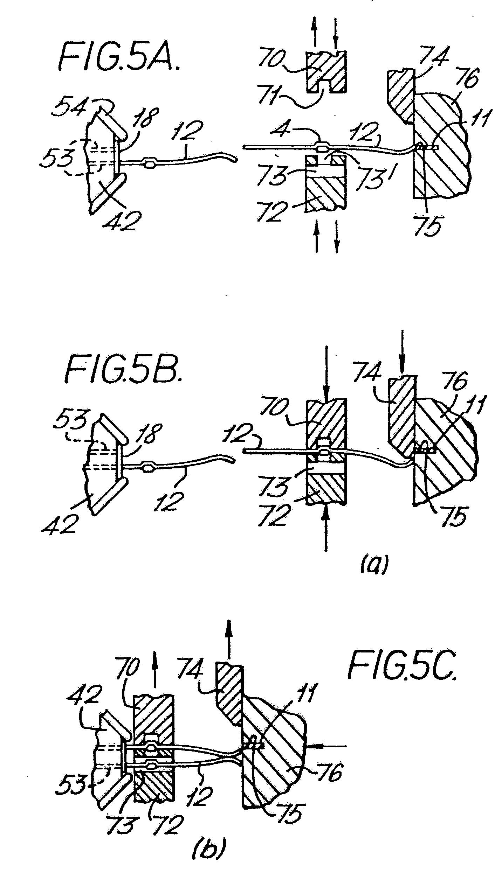

Terminal insertion tooling of the press 201 will now be described with reference to Figs. 5A, 5B and 5C. The terminal insertion tooling of the press 200 is similar but is somewhat simpler than that of the press 201, as described below. When the jig 42 is positioned at station C, one row of terminals 12 has, as shown in Fig. 5A, already been inserted into one row of bores 53 of the jig 42, by the terminal insertion tooling of the press 200. The terminal insertion tooling of the press 201, comprises a fixed tool 76 having a slot 75 receiving the carrier strip 11 so that the terminals 12 project between movable vice members 70 and 72 of the press 201. The vice member 70 has a recess 71, the vice member 72 having opposite thereto a recess 73', these recesses being dimensioned to receive in co-operation with on one another, the enlarged portions 4 of the terminals 12. The recess 73' communicating with transverse bores 73 (only one of which is shown) extending through the vice member 72 and being dimensioned to receive the terminals 12 of the first row. Adjacent to the tool 76 is a shear blade 74 which is movable relative thereto. The movable parts of the tooling are operated by ram means (not shwon) of the press 201.

As shown in Fig. 5, the terminals 12 are fed between the members 70 and 72 when these are in the open position. As shown in Fig. 5B, the members 70 and 72 are then closed to grip the terminals 12 and the blade 74 is depressed to shear the terminals 12 from the carrier strip 11. The press 201 is then advanced towards the jig 42 to advance the tooling from position (a) in Fig. 5B to position (b) in Fig. 5C, whereby the terminals 12 of the second row are inserted into the bores 53 of the other row of such bores of the jig 42, the blade 74 being retracted, as shown in Fig. 5C. As shwon in Fig. 5C, the terminals 12 of the first row are received in the bores 73 so that damage to these terminals is avoided. The vice member 70 is then opened to free the newly inserted terminals 12. The press 201 is finally returned to its initial position to retract the tooling to position (a) and the vice member 72 is returned to its position of Fig. 5A.

As mentioned above, the terminal insertion tooling (not shown) of the press 200 is similar to that of the press 201. However, the former tooling is the simpler in that no bore equivalent to the bore 73 is required, and in that both vice members are opened prior to their retraction from the jig 42.

A connector housing applicator 202 (Fig. 3) associated with station D comprises, as shown in Figs. 7A, 7B and 7C, side plates 80 and 82, which define a guide passage 83 for a housing 16, and a housing applicator tool 84 driven by a ram 86 actuated by drive means (not shown). The tool 84 has a projecting mandrel 85 for insertion into the channel 17 of the housing 16 to spread apart the contact springs 8 of the two rows, as shown in Fig. 8, to avoid damage to the springs 8 during the application of the housing 16. Housing 16 may be fed automatically into the passage 83 by means not shown e. g. from a magazine containing a supply of housings 16.

As will be apparent from Figs. 7B and 7C, the housing 16 in the passage 83 is advanced by the tool 84, whilst the jig 42 dwells at station D, so that housing 16 is pushed by the tool 84 over the two rows of terminals 12 carried by the jig 42.

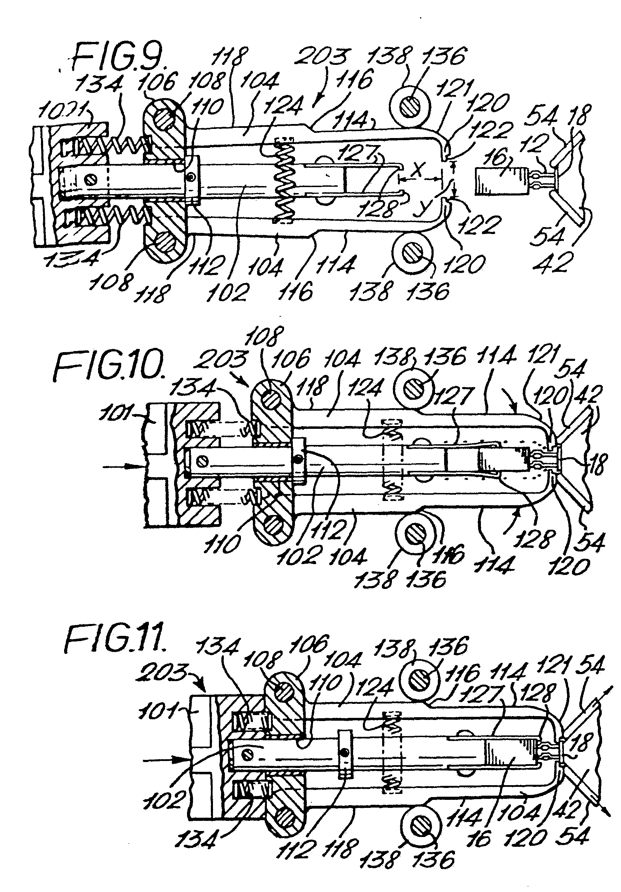

As shown in Fig. 3, a connector stripper assembly 203 associated with station E is mounted on a base 204 by way of a shaft socket 101. As will be apparent from Figs. 9 to 13, the socket 101 in which a shaft 102 is secured, is movable towards and away from the jig 42, for example by means of a pneumatically or hydraulically driven ram (not shown). On the shaft 102 is a collar plate 106 to which are mounted the rear ends of jaws 104, on pivot pins 108, the jaws 104 being urged apart from one another by a spring 124. At its end remote from the pin 108, each jaw 104 is formed as a J-hook 120, the free ends of the hooks 120 being oppositely directed and being in alignment with one another. The tips of the jaws 104 are formed with opposed notches 122. The shaft 102 extends slidably through a bush 110 in the collar plate 106, a collar 122 being fixed to the shaft 102 at a position beyond the plate 106, springs 134 acting between the socket 101 and the collar plate 106 to urge the latter towards the collar 112. Each jaw 104 has external, rectilinear cam follower surfaces 114 and 118 displaced lengthwise of the jaw 104 and being connected by a cam follower surface 116 which is inclined relative to the surfaces 114 and 118. Each surface 114 is followed, lengthwise of the jaw 104, by a convex cam surface 121 constituted by the external surface of the hook 120 of the jaw 104. The cam follower surfaces 114, 116 and 118 co-operate with camming rollers 138 rotatable about shafts 136 which are fixed with respect to the base 204. The surfaces 121 co-operate with the plates 54 of the jig 42 as explained below.

A receptacle for a housing 16 is constituted by cantilever springs 127 secured to the free end of the shaft 102 remote from the socket 101 and terminating at their free ends in inwardly directed J-hooks 128.

Whilst the jig 42 dwells at station E, the assembly 203 is initially positioned relative thereto as shown in Fig. 9, with the rollers 138 engaging the surfaces 114 of the jaws 104 which are in their open position under the action of the spring 124, the tips of the jaws 104 being spaced from one another by a distance y which slightly exceeds the width of the housing 16 of the connector assembly carried by the jig 42. The extremities of the hooks 128 are spaced from the inner surfaces of the tips of the hooks 120 by a distance x equal to that between the strip 18 and the housing 16 on the jig 42.

The socket 101 is now advanced towards the jig 42, so that the rollers 138 ride over the surfaces 116, as shown in Fig. 10, to cam the jaws 104 towards one another against the action of the spring 124. The springs 134 are also compressed, but only to a slight extent. The surfaces 116 are so angled and positioned that as the jaws 104 begin to close, the surfaces 121 thereof engage the plates 54 of the jig 42. As the jaws 104 move towards their closed position (see Fig. 10) the surfaces 121 cam the plates 54 away from the strip 18 there between, to the full extent of the travel of the plates 54 as delimited by the slots 55 therein. The strip 18 is thereby released from the jig 42. During the closure of the jaws 104, the springs 127 are advanced with the socket 101, towards the jig 42, the path of movement of the tips of the hooks 120 being indicated by dotted lines in Fig. 10. As the plates 54 are being retracted, the housing 16 enters between the springs 128 (see Fig. 10), which are cammed apart as a result of the engagement of the housing 16 against the hooks 128. The housing 16 ist thereby secured between the springs 128 prior to the release of the strip 18.

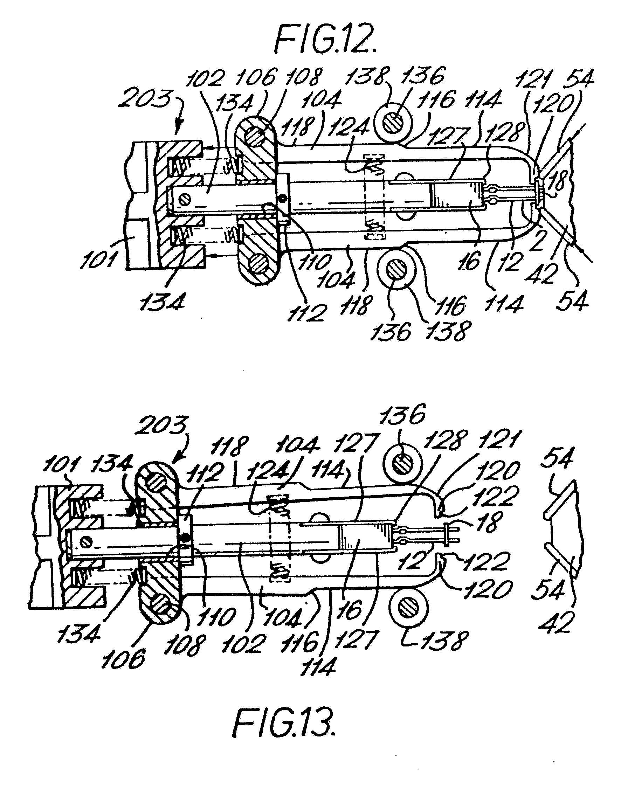

As the socket 101 is advanced from its Fig. 10 to its Fig. 11 position, the collar 112 is displaced from the plate 106 until the springs 134 are fully compressed, as shown in Fig. 11 (the advance of the jaws 104 being limited by the plates 54) until the socket 101 comes to rest against the plate 106 and the housing 16 is fully received between the springs 127 and is retained in position therebetween by the hooks 128. The strip 18 is now received in the notches 122 of the hooks 120, having thereby passed beyond the surfaces 121, and is held in position by the walls of the notches 122. The socket 101, and thus the shaft 102, is now retracted (Fig. 12), whereby the housing 16 is pulled away from the strip 18, which is held in the notches 122, so that the posts 2 are partially withdrawn from the strip 18. The strip 18 is accordingly moved relatively nearer to the free ends of the posts 2, e. g. up to a distance 0f 2.54 mm therefrom, until the collar 112 re-engages the plate 106. During the movement of the collar 112 towards the plate 106, the springs 134 bias the hooks 120 against the plates 54.

As the socket 101 is further retracted, the rollers 138 ride back over the surfaces 116 so that the jaws 104 are opened again (Fig. 13) and the finished connector assembly can be removed from between the springs 127.

## Claims

1. An electrical connector assembly comprising a plurality of electrical terminals (12) each having an electrical contact portion (8) and an electrical connecting post (2) having a free end, an insulating housing (16) enclosing the contact portions (8) of the terminals (12) and from which housing (16) the connecting posts (2) of the terminals (12) project, the posts (2) extending through holes (13') in an insulating strip (18) which serves to retain the posts (2) in parallel relationship with one another, the terminals (12) having enlarged portions intermediate their ends and the strip (18) being positioned between the free ends of the posts (2) and the enlarged portions (4); characterised in that the malleability of the material of the strip (18) and the thickness thereof are so chosen, and the enlarged portions (4) which portions (4) are on the posts (2), are so shaped, that the enlarged portions (4) can be forced through the holes (13') in the strip (18).

2. An assembly according to Claim 1, characterised in that the insulating strip (18) is positioned not more than 8 mm from the free ends of the posts (2).

3. An assembly according to Claim 2, characterised in that the strip (18) is positioned at a distance of substantially 2.54 mm from the ends of the posts (2).

4. An assembly according to Claim 1, 2 or 3, characterised in that the thickness of the strip (18) is substantially 0.127 mm, the strip being made of polytetrafluoroethylene.

5. Apparatus for manufacturing an assembly according to Claim 1, characterised by a jig (42) having a strip receiving face (64) on which the insulating strip (18) is positioned, bores (53) in the jig (42) communicating with the strip receiving face (64) of the jig (42), each bore (53) being in alignment with one of the holes (13') in the strip (18); means (54) securing the strip (18) releasably on the strip receiving face (64); means (40) for moving the jig (42) along a strip (18) conveying path; terminal insertion tooling (200) mounted beside the path at a terminal insertion station (B or C) of the jig (42) and comprising a vice (70, 72) for gripping a plurality of the terminals (12), the vice (70, 72) being movable towards the conveying path to insert the posts (2) of the terminals (12) through the holes (13') in the strip (18) and into the bores (53) of the jig (42); a housing applicator (202) mounted beside the conveying path at a housing application station (D) downstream of the terminal application station (B or C) and being adapted to position the housing (16) over the contact portions (8) of the terminals (12); and connector assembly stripping tooling (203) mounted at a connector assembly stripping station (E) of the jig (42) downstream of the housing application station (D) and being adapted to release the strip (18) from the strip securing means (54) and to withdraw from the jig (42), the housing (16) with the terminals (12) therein and the posts (2) of the terminals extending through the holes (13') in the strip (18), the stripping tooling (203) comprising means (106, 112, 120, 127, 134) for positioning the insulating strip (18) in the vicinity of the free ends of the posts (2).

6. Apparatus accorrding to Claim 5, characterised by further terminal insertion tooling (201) mounted beside the conveying path, at a further terminal insertion station (C) of the jig (42) downstream of the first mentioned insertion tooling (200), and upstream of the housing application station (D), the further terminal insertion tooling comprising a furhter vice (70, 72) for gripping a further plurality of the terminals (12) and being movable towards the conveying path to insert the further terminals (12) into further bores (53) in the stripreceiving face (64) of the jig (42), one member (72) of the further vice (70, 72) having openings (73) for receiving the contact portions (8) of the terminals (12) of the first mentioned plurality of terminals (12), and the other member (70) of the further vice (70, 72) being opened prior to being retracted away from the conveying path.

7. Apparatus according to Claim 6, characterised in that the housing applicator (202) comprises, a passage (83) in which the housing (16) is slidable, and a ram (86) carrying a projection (85), the ram (86) serving to drive the housing (16) over the two rows of terminals (12) and the projection (85) serving to spread apart the contact portions (8) of the two rows of terminals (12).

8. Apparatus according to Claim 5, 6 or 7, characterised in that the strip securing means of the jig (42) comprises a securing member (54) urged by a spring (58) against an edge of the insulating strip (18) on the strip receiving face (64) of the jig (42), a jaw (104) of the connector stripping tooling (203) acting to retract the securing member (54) against the action of the spring (58) as the housing (16) is being received in a receptacle (127, 127) of the stripping tooling (203).

9. Apparatus according to Claim 8, characterised in that when the housing (16) has been received in the receptacle (127, 127) the latter is retracted to draw the insulating strip (18) against the jaw (104) and partially to withdraw the posts (2) of the terminals (12) from the holes (13') in the strip (18).

10. A method of manufacturing an assembly according to Claim 1, characterised by the steps of securing the insulating strip (18) in a jig (42), the holes (13') in the strip (18) being arranged in first and second parallel rows, and each such hole (13') being axially aligned with one of a plurality of bores (53) in the jig (42); employing first insertion tooling (200) to insert the free end of the post (2) of each terminal (12) of a first row of terminals (16) through one of the holes (13') of the first row and into the bore (53) aligned therewith; employing second insertion tooling (201) to insert the free end of the post (2) of each terminal (12) of a second row of terminals (12) through one of the holes (13') of the second row and into the bore (53) aligned therewith; employing a housing applicator (202) to secure the housing (16) about the contact portions (8) of the two rows of terminals (12) held by the jig (42); and employing locating and stripping tooling (203) to position the insulating strip (18) in the vicinity of the ends of the posts (2) of the terminals of the two rows and to remove the finished assembly (12, 16, 18) from the jig (42).

**Patentansprüche**

1. Elektrische Verbinderanordnung mit mehreren elektrischen Anschlüssen (12), von denen jeder einen elektrischen Kontaktteil (8) und einen elektrischen Verbindungsstift (2) mit einem freien Ende aufweist, einem Isoliergehäuse (16), das die Kontaktteile (8) der Anschlüsse (12) umgibt und von dem die Verbindungsstifte (2) der Anschlüsse (12) hervorstehen, wobei sich die Stifte (2) durch Löcher (13') in einem Isolierstreifen (18) hindurcherstrecken, der zum Halten der Stifte (2) in parallelem Verhältnis zueinander dient, die Anschlüsse (12) vergrößerte Abschnitte zwischen ihren Enden aufweisen und der Streifen (18) zwischen den freien Enden der Stifte (2) und den vergrößerten Abschnitten (4) positioniert ist, dadurch gekennzeichnet, daß die Dehnbarkeit des Materials des Streifens (18) sowie die Dicke desselben so gewählt sind und die vergrößerten Abschnitte (4), die sich an den Stiften (2) befinden, so geformt sind, daß die vergrößerten Abschnitte (4) durch die Löcher (13') in dem Streifen (18) gezwängt werden können.

2. Anordnung nach Anspruch 1, dadurch gekennzeichnet, daß der Isolierstreifen (18) nicht mehr als 8 mm von den freien Enden der Stifte (2) positioniert ist.

3. Anordnung nach Anspruch 2, dadurch gekennzeichnet, daß der Streifen (18) in einem Abstand von im wesentlichen 2,54 mm von den Enden der Stifte (2) positioniert ist.

4. Anordnung nach Anspruch 1, 2 oder 3, dadurch gekennzeichnet, daß die Dicke des Streifens (18) im wesentlichen 0,127 mm beträgt und der Streifen aus Polytetrafluoräthylen besteht.

5. Vorrichtung zum Zusammenbau einer Anordnung nach Anspruch 1, gekennzeichnet durch
eine Einspannvorrichtung (42) mit einer Streifenaufnahmefläche (64), auf der der Isolierstreifen (18) positioniert ist, wobei Bohrungen (53) in der Einspannvorrichtung (42) mit der Streifenaufnahmefläche (64) der Einspannvorrichtung (42) in Verbindung stehen und jede Bohrung (53) mit einem der Löcher (13') in dem Streifen (18) ausgerichtet ist;
eine Einrichtung (54) zur lösbaren Befestigung des Streifens (18) auf der Streifenaufnahmefläche (64);
eine Einrichtung (40) zur Bewegung der Einspannvorrichtung (42) entlang einer Förderbahn des Streifens (18);
eine Anschlußeinsetz-Werkzeugeinrichtung (200), die neben der Bahn an einer Anschlußeinsetzstation (B oder C) der Einspannvorrichtung (42) angeordnet ist und eine Greifeinrichtung (70, 72) zum Greifen von mehreren der Anschlüsse (12) aufweist, wobei die Greifeinrichtung (70, 72) zum Einsetzen der Stifte (2) der Anschlüsse (12) durch die Löcher (13') in dem Streifen (18) sowie in die Bohrungen (53) der Einspannvorrichtung (42) hinein in Richtung auf die Förderbahn bewegbar ist;
eine Gehäuseaufsetzeinrichtung (202), die neben der Förderbahn an einer Gehäuseaufsetzstation (D) hinter der Anschlußeinsetzstation (B oder C) angeordnet ist und dazu ausgelegt ist, das Gehäuse (16) über den Kontaktteilen (8) der Anschlüsse (12) zu positionieren; und
eine Verbinderanordnung-Abstreifwerkzeugeinrichtung (203), die an einer Verbinderanordnung-Abstreifstation (E) der Einspannvorrichtung (42) hinter der Gehäuseaufsetzstation (D) angeordnet ist und zum Lösen des Streifens (18) von der Streifenbefestigungseinrichtung (54) sowie zum Herausziehen des Gehäuses (16) mit den darin befindlichen Anschlüssen (12) und der sich durch die Löcher (13') in dem Streifen (18) erstreckenden Stifte (2) der Anschlüsse aus der Einspannvorrichtung (42) dient, wobei die Abstreifwerkzeugeinrichtung (203) Einrichtungen (106, 112, 120, 127, 134) zum Positionieren des Isolierstreifens (18) in der Nähe der freien Enden der Stifte (2) aufweist.

6. Vorrichtung nach Anspruch 5, gekennzeichnet durch eine weitere Anschlußeinsetz-Werkzeugeinrichtung (201), die neben der Förderbahn an einer weiteren Anschlußeinsetzstation (C) der Einspannvorrichtung (42) hinter der erstgenannten Einsetz-Werkzeugeinrichtung (200) und vor der Gehäuseaufsetzstation (D) angeordnet ist, wobei die weitere Anschlußeinsetz-Werkzeugeinrichtung eine weitere Greifeinrichtung (70, 72) zum Greifen einer weiteren Anzahl von Anschlüssen (12) aufweist und zum Einsetzen der weiteren Anschlüsse (12) in weitere Bohrungen (53) in der Streifenaufnahmefläche (54) der Einspannvorrichtung (42) in Richtung auf die Förderbahn bewegbar ist, wobei ein Element (72) der weiteren Greifeinrichtung (70, 72) Öffnungen (73) zur Aufnahme der Kontaktteile (8) der Anschlüsse (12) der erstgenannten Anzahl von Anschlüssen (12) aufweist, und das andere Element (70) der weiteren Greifeinrichtung (70, 72) vor dem Zurückziehen desselben von der Förderbahn geöffnet wird.

7. Vorrichtung nach Anspruch 6, dadurch gekennzeichnet, daß die Gehäuseaufsetzeinrichtung (202) eine Durchführung (83), in der das Gehäuse (16) verschiebbar ist, und ein Rammteil (86) mit einem Vorsprung (85) aufweist, wobei das Rammteil (86) dazu dient, das Gehäuse (16) über die beiden Reihen von Anschlüssen (12) zu treiben, und der Vorsprung (85) dazu dient, die Kontaktteile (8) der beiden Reihen von Anschlüssen (12) auseinanderzuspreizen.

8. Vorrichtung nach Anspruch 5, 6 oder 7, dadurch gekennzeichnet, daß die Streifenbefestigungseinrichtung der Einspannvorrichtung (42) ein Befestigungselement (54) aufweist, das mittels einer Feder (58) gegen eine Kante des Isolierstreifens (18) auf der Streifenaufnahmefläche (64) der Einspannvorrichtung (42) gedrängt wird, wobei eine Backe (104) der Verbinder-Abstreifwerkzeugeinrichtung (203) zum Zurückziehen des Befestigungselements (54) gegen die Wirkung der Feder (58) dient, wenn das Gehäuse (16) in einem Aufnahmeteil (127, 127) der Abstreifwerkzeugeinrichtung (203) aufgenommen ist.

9. Vorrichtung nach Anspruch 8, dadurch gekennzeichnet, daß dann, wenn das Gehäuse (16) in dem Aufnahmeteil (127, 127) aufgenommen ist, Letzteres zurückgezogen wird, um den Isolierstreifen (18) gegen die Backe (104) zu ziehen und um die Stifte (2) der Anschlüsse (12) teilweise aus den Löchern (13') in dem Streifen (18) herauszuziehen.

10. Verfahren zum Zusammenbau einer Anordnung nach Anspruch 1, gekennzeichnet durch folgende Schritte:

Befestigen des Isolierstreifens (18) in einer Einspannvorrichtung (42), wobei die Löcher (13') in dem Streifen (18) in einer ersten und einer zweiten parallelen Reihe angeordnet sind und jedes derartige Loch (13') mit einer von vielen Bohrungen (53) in der Einspannvorrichtung (42) axial ausgerichtet ist;

Verwendung einer ersten Einsetz-Werkzeugeinrichtung (200) zum Einsetzen des freien Endes des Stifts (2) jedes Anschlußes (12) einer ersten Reihe von Anschlüssen (12) durch eines der Löcher (13') der ersten Reihe in die damit ausgerichtete Bohrung (53);

Verwendung einer zweiten Einsetz-Werkzeugeinrichtung (201) zum Einsetzen des freien Endes des Stifts (2) jedes Anschlußes (12) einer zweiten Reihe von Anschlüssen (12) durch eines der Löcher (13') der zweiten Reihe in die damit ausgerichtete Bohrung (53);

Verwendung einer Gehäuseaufsetzeinrichtung (202) zur Befestigung des Gehäuses (16) um die Kontaktteile (8) der beiden Reihen von Anschlüssen (12), die von der Einspannvorrichtung (42) gehalten werden; und

Verwendung einer Positionierungs- und Abstreif-Werkzeugeinrichtung (203) zur Positionierung des Isolierstreifens (18) in der Nähe der Enden der Stifte (2) der Anschlüsse der beiden Reihen sowie zur Entfernung der fertiggestellten Anordnung (12, 16, 18) von der Einspannvorrichtung (42).

## Revendications

1. Ensemble à connecteur électrique comprenant plusieurs bornes électriques (12) ayant chacune une partie de contact électrique (8) et une broche (2) de connexion électrique qui comporte une extrémité libre, un boîtier isolant (16) renfermant les parties de contact (8) des bornes (12), boîtier (16) duquel les broches (2) de connexion des bornes (12) font saillie, les broches (2) passant dans des trous (13') d'une bande isolante (18) qui sert à retenir les broches (2) parallèlement les unes aux autres, les bornes (12) comportant des parties élargies situées entre leurs extrémités et la bande (18) étant positionnée entre les extrémités libres des broches (2) et les parties élargies (4), caractérisé en ce que la malléabilité de la matière de la bande (18) et son épaisseur sont choisies, et en ce que les parties élargies (4), lesquelles parties (4) sont situées sur les broches (2), sont configurées de manière que les parties élargies (4) puissent être introduites à force dans les trous (13') de la bande (18).

2. Ensemble selon la revendication 1, caractérisé en ce que la bande isolante (18) n'est pas placée à plus de 8 mm des extrémités libres des broches (2).

3. Ensemble selon la revendication 2, caractérisé en ce que la bande (18) est placée à une distance d'environ 2,54 mm des extrémités des broches (2).

4. Ensemble selon la revendication 1, 2 ou 3, caractérisé en ce que l'épaisseur de la bande (18) est d'environ 0,127 mm, la bande étant réalisée en polytétrafluoréthylène.

5. Appareil pour la fabrication d'un ensemble selon la revendication 1, caractérisé par un gabarit (42) présentant une face (64) de réception d'une bande sur laquelle la bande isolante (18) est positionnée, des alésages (53) du gabarit (42) communiquant avec la face (64) de réception d'une bande du gabarit (42), chaque alésage (53) étant aligné avec l'un des trous (13') de la bande (18); un dispositif (54) fixant la bande (18) de manière amovible sur la face (64) de réception de la bande; un dispositif (40) pour déplacer le gabarit (42) le long d'un trajet d'avance de la bande (18); un outillage (200) d'insertion de bornes monté à côté du trajet, dans un poste (B ou C) d'insertion de bornes du gabarit (42) et comprenant un étau (70, 72) pour serrer plusieurs des bornes (12), l'étau (70, 72) pouvant être déplacé vers le trajet d'avance pour insérer les broches (2) des bornes (12) dans les trous (13') de la bande (18) et dans les alésages (53) du gabarit (42); un dispositif (202) de pose de boîtier monté à côté du trajet d'avance, dans un poste (D) de pose de boîtier, en aval du poste (B ou C) de pose de bornes, et destiné à positionner le boîtier (16) audessus des parties de contact (8) des bornes (12); et un outillage (203) de dégagement de l'ensemble à connecteur monté dans un poste (E) de dégagement d'un ensemble à connecteur du gabarit (42), en aval du poste (D) de pose de boîtier et destiné à libérer la bande (18) du dispositif (54) de fixation de la bande et à retirer du gabarit (42) le boêtier (16) et les bornes (12) qu'il contient, les broches (2) des bornes passant dans les trous (13') de la bande (18), l'outillage (203) de dégagement comprenant des moyens (106, 112, 120, 127, 134) pour positionner la bande isolante (18) à proximité des extrémités libres des broches (2).

6. Appareil selon la revendication 5, caractérisé par un autre outillage (201) d'insertion de bornes monté à côté du trajet d'avance, dans un autre poste (C) d'insertion de bornes du gabarit (42), en aval du premier outillage d'insertion cité (200), et en amont du poste (D) de pose de boîtier, l'autre outillage d'insertion de bornes comprenant un autre étau (70, 72) destiné à serrer d'autres bornes (12) et pouvant se déplacer vers le trajet d'avance pour insérer les autres bornes (12) dans d'autres alésages (53) de la face (64) de réception de bande du gabarit (42), un premier élément (72) de l'autre étau (70, 72) présentant des trous (73) destinés à recevoir les parties (8) de contact des bornes (12) des premières bornes (12) citées, et l'autre élément (70) de l'autre étau (70, 72) étant ouvert avant d'être éloigné du trajet d'avance.

7. Appareil selon la revendication 6, caractérisé en ce que le dispisitif (202) de pose de boîtier comprend un passage (83) dans lequel le boîtier (16) peut coulisser, et un coulisseau (86) qui porte une saillie (85), le coulisseau (86) servant à entraîner le boîtier (16) audessus des deux rangées de bornes (12) et la saillie (85) servant à écarter les parties (8) de contact des deux rangées de bornes (12).

8. Appareil selon la revendication 5, 6 ou 7, caractérisé en ce que le dispositif de fixation de bande du gabarit (42) comprend un élément (54) de fixation qu'un ressort (58) tend à déplacer contre un bord de la bande isolante (18) placée sur la face (64) de réception de bande du gabarit (42), une mâchoire (104) de l'outillage (203) dégagement du connecteur agissant de manière à rétracter l'élément (54) de fixation contre l'action du ressort (58) lorsque le boîtier (16) est placé dans un logement (127, 127) de l'outillage (203) de dégagement.

9. Appareil selon la revendication 8, caractérisé en ce que, lorsque le boîtier (16) a été placé dans le logement (127, 127), ce dernier est rétracté pour tirer la bande isolante (18) contre la mâchoire (104) et retirer partiellement les broches (2) des bornes (12) des trous (13') ménagés dans la bande (18).

10. Procédé pour la fabrication d'un ensemble selon la revendication 1, caractérisé par les étapes consistant à fixer la bande isolante (18) dans un gabarit (42), les trous (13') de la bande (18) étant disposés en première et seconde rangées parallèles, et chaque trou (13') étant aligné axialement avec l'un de plusieurs alésages (53) du gabarit (42); à utiliser un premier outillage (200) d'insertion pour insérer l'extrémité libre de la broche (2) de chaque borne (12) d'une première rangée de bornes (16) par l'un des trous (13') de la première rangée et dans l'alésage (53) aligné avec lui; à utiliser un second outillage (201) d'insertion pour insérer l'extrémité libre de la broche (2) de chaque borne (12) d'une seconde rangée de bornes (12) par l'un des trous (13') de la seconde rangée et dans l'alésage (53) aligné avec lui; à utilisier un dispositif (202) de pose de boîtier pour fixer le boîtier (16) autour des parties (8) de contact des deus rangées de bornes (12) maintenues par le gabarit (42); et à utiliser un outillage (203) de positionnement et de dégagement pour positionner la bande isolante (18) à proximité des extrémités des broches (2) des bornes des deux rangées et pour enlever l'ensemble fini (12, 16, 18) du gabarit (42).

FIG.1.

FIG.2.

FIG.1A.

FIG.3.

FIG.4.

42

55
54

54

55
56

64  53

IVA

58

59

60

55

56

52
50

48

62

46

44

IVA

FIG.4A.

54 13' 18 13'  53 54

56  58

55  56

42  59

53'

60

62

52

50

48

46  44

40

FIG.5A.

FIG.5B.

*(a)*

FIG.5C.

*(b)*

FIG.6.

FIG.8.

FIG.7A.

FIG.7B.

FIG.7C.

FIG.9.

FIG.10.

FIG.11.

0 007 183

21

# FIG.12.

# FIG.13.